# EUROPÄISCHE PATENTANMELDUNG

(11) **EP 1 172 946 A2**
(43) Veröffentlichungstag der Anmeldung: **16.01.2002**
(21) Anmeldenummer: 01116899.4
(22) Anmeldetag: 11.07.2001
(51) Int. Cl.: H04B 7/12, H04H 1/00

(54) **Empfänger für den Empfang von Rundfunksignalen, mit Verwendung mehrerer Empfängern, und Betriebsverfahren dafür**

(30) Priorität: 13.07.2000 DE 10034039
(71) Anmelder: BECKER GmbH, D-76307 Karlsbad (DE)
(72) Erfinder: Gierl, Stefan, 76133 Karlsruhe (DE)
(74) Vertreter: Patentanwälte Westphal, Mussgnug & Partner

(57) **Zusammenfassung**

Ein Rundfunkempfangssystem umfaßt eine Mehrzahl von einer gemeinsamen Ausgabeeinrichtung (3) zugeordneten Empfängern (1a, 1b, 1c, 1d). Jeweils einer der Empfänger, als Hörempfänger (1a) bezeichnet, ist auf eine Frequenz eines Rundfunksenders abgestimmt und liefert ein von dem Sender empfangenes Signal zur Ausgabe an die Ausgabeeinrichtung (3). Wenigstens ein zweiter Empfänger (1a, 1b), als Suchempfänger bezeichnet, sucht das Empfangsfrequenzband fortlaufend nach anderen Frequenzen des gleichen Senders ab. Das System wechselt auf eine von dem Suchempfänger (1b, 1c) gefundene Frequenz, wenn die Qualität des von dem Hörempfänger (1a) empfangenen Signals einen Grenzwert unterschreitet.

## Beschreibung

Die vorliegende Erfindung betrifft ein Rundfunkempfangssystem, einen Empfänger und ein Betriebsverfahren dafür.

Rundfunkempfänger mit einer sogenannten Autobest-Funktionalität sind seit längerem bekannt. Diese Empfänger, die insbesondere für Autoradios angewendet werden, zeichnen sich dadurch aus, daß sie in der Lage sind, wenn die Empfangsqualität eines Senders, auf den sie abgestimmt sind, einen Grenzwert unterschreitet, selbsttätig eine andere Frequenz des gleichen Senders aufzusuchen, der eine bessere Empfangsqualität gewährleistet, und sich auf diese Frequenz abzustimmen. Dies ermöglicht es einem Autofahrer, auch bei Fahrten über große Entfernungen, die die Reichweite einer einzelnen UKW-Sendestation überschreiten, gleichbleibend einen Sender zu hören, ohne selbst nach einer Ausweichfrequenz suchen zu müssen, wenn der Empfang auf der gegenwärtig eingestellten Frequenz unbefriedigend wird.

Auch diese Empfänger ermöglichen jedoch kein unterbrechungsfreies Hören, denn der Vorgang des Suchens einer Frequenz des gleichen Senders kann beträchtliche Zeit in Anspruch nehmen, innerhalb derer der Empfänger sich wiederholt auf andere Senderfrequenzen abstimmt und überprüft, ob der dort empfangene Sender mit dem ursprünglichen identisch ist. Wenn eine solche Unterbrechung zufällig während der Übertragung von Verkehrsmeldungen wie etwa Stauwarnungen etc. auftritt, so ist dies für den Anwender äußerst unbefriedigend, selbst wenn die Unterbrechung nur wenige Sekunden dauert.

Derartige Unterbrechungen des Empfangs lassen sich mit einem Rundfunkempfangssystem der in DE 196 18 755 A1 beschriebenen Art vermeiden. Dieses Empfangssystem umfaßt eine Mehrzahl von Autobest-Empfängern, die jeweils auf einen gleichen Sender abgestimmt sind und untereinander auf einem Ring Daten austauschen, die das Empfangssignal sowie eine Information über die Empfangsqualität der einzelnen Empfänger beinhalten. Ein Empfänger, der solche Daten von einem auf dem Ring benachbarten Empfänger erhält, ersetzt diese durch sein eigenes Empfangssignal und die zugehörige Qualitätsinformation, wenn die Qualität des eigenen Signals besser ist als die des vom Nachbarempfänger erhaltenen. Falls die eigene Empfangsqualität schlechter ist, wird das vom Nachbarempfänger erhaltene Signal unverändert weitergegeben. Dadurch wird erreicht, daß das auf dem Ring umlaufende Empfangssignal, welches schließlich als Hörsignal ausgegeben wird, das jeweils beste unter den Empfangssignalen aller Empfänger ist. Falls die Qualität eines Empfängers so schlecht wird, daß er eine neue Empfangsfrequenz suchen muß, so bleibt dies so lange für einen Benutzer des Rundfunkempfangssystems unhörbar, wie es andere Empfänger gibt, die ein Empfangssignal mit befriedigender Qualität auf dem Ring ausgeben können.

Da jeder Empfänger aber nur so lange nach einer Alternativfrequenz sucht, bis er eine mit befriedigender Qualität gefunden hat, hat das auf dem Ring zirkulierende Empfangssignal meist nicht die beste Qualität, die unter Berücksichtigung aller zur Verfügung stehenden Frequenzen eines Senders erreichbar ist.

Aufgabe der vorliegenden Erfindung ist, ein Verfahren zum Betreiben eines Rundfunkempfangssystems bzw. ein Rundfunkempfangssystem und einen Empfänger, die zur Durchführung eines solchen Verfahrens geeignet sind, anzugeben, durch die gewährleistet ist, daß stets die beste mögliche Empfangsfrequenz genutzt wird.

Der Erfindung liegt die Einsicht zugrunde, daß in einem Rundfunkempfangssystem mit mehreren Empfängern die herkömmliche Autobest-Suchstrategie keine optimalen Ergebnisse liefern kann, weil sie darauf ausgelegt ist, nach einer möglichst kurzen Unterbrechung wieder ein Hörsignal zu liefern, daß dies aber bei einem Rundfunkempfangssystem mit mehreren Empfängern jedoch nicht bei jedem einzelnen Empfänger erforderlich ist. Das heißt, wenn bei einem Rundfunkempfangssystem mit mehreren Empfängern eine Unterscheidung zwischen einem Hörempfänger, der das für einen Benutzer hörbare Signal liefern soll, und anderen Empfängern getroffen wird, die dies nicht müssen, so können diese anderen Empfänger zu einer systematischen Suche nach der bestmöglichen Empfangsfrequenz eingesetzt werden. Es wird deshalb ein Verfahren zum Betreiben eines Rundfunkempfangssystems mit einer Mehrzahl von einer gemeinsamen Ausgabeeinrichtung zugeordneten Empfängern vorgeschlagen, bei dem jeweils einer der Empfänger, als Hörempfänger bezeichnet, auf eine Frequenz eines Rundfunksenders abgestimmt ist, und ein von dem Sender empfangenes Signal zur Ausgabe an die Ausgabeeinrichtungen liefert, und das dadurch gekennzeichnet ist, daß wenigstens ein zweiter Empfänger, als Suchempfänger bezeichnet, das Empfangsfrequenzband fortlaufend nach anderen Frequenzen des gleichen Senders absucht und eine Information über die Empfangsqualität bei jeder gefundenen Frequenz speichert, und daß das System auf eine von dem Suchempfänger gefundene Frequenz wechselt, wenn die Qualität des von dem Hörempfänger empfangenen Signals einen Grenzwert unterschreitet.

Dabei ist der Ausdruck "fortlaufend" nicht so zu verstehen, daß der Suchempfänger das Frequenzband pausenlos nach Alternativfrequenzen des am Hörempfänger eingestellten Senders absuchen müßte. Es können durchaus Pausen zwischen zwei Suchvorgängen vorgesehen werden, in denen der Suchempfänger untätig ist oder für eine andere Aufgabe eingesetzt wird. Entscheidend ist, daß der Suchvorgang nicht mit dem Auffinden der ersten einer gegebenen Qualitätsanforderung genügenden Alternativfrequenz abbricht, sondern weiterläuft, so daß auch die jeweils beste Frequenz des betreffenden Senders zwangsläufig gefunden wird und entschieden werden kann, ob das System zu dieser Frequenz wechselt oder nicht. Der Grenzwert, der dieser Entscheidung zugrundegelegt wird, kann in herkömmlicher Weise absolut festgelegt werden, z.B. derart, daß bei Unterschreitung einer vorgegebenen Empfangsfeldstärke oder eines vorgegebenen Signal-Rausch-Abstandes, auf eine bessere Empfangsfrequenz umgeschaltet wird.

Anstelle einer solchen Vorgehensweise, die bei Empfangssystemen mit einem einzigen Empfänger sinnvoll sind, um die Zahl der Empfangsunterbrechungen gering zu halten, kann aber bei einem Empfangssystem mit mehreren Empfängern gemäß der Erfindung der Grenzwert auch relativ bezogen auf die Qualität einer von dem Suchempfänger gefundenen Frequenz festgelegt werden. Das heißt, wenn die von dem Suchempfänger gefundene Frequenz besser als die aktuell vom Hörempfänger verwendete ist oder ihre Qualität abzüglich eines Hysteresewertes besser als die der aktuell verwendeten Frequenz ist, wird ein Wechsel der Empfangsfrequenz durchgeführt. Auf diese Weise ist gewährleistet, daß die Empfangsqualität niemals weiter als nötig unter das Optimum abfällt. Bei einer ersten Ausgestaltung dieses Verfahrens sucht der Suchempfänger das gesamte Frequenzband ab, entscheidet, welche der darin gefundenen Alternativfrequenzen die beste Qualität aufweist und meldet diese Frequenz an den Hörtuner. Auf diese Weise wird durch einen einzigen Frequenzwechsel der Hörempfänger auf die beste Frequenz eingestellt. Bei einer zweiten Ausgestaltung meldet der Suchempfänger alle gefundenen Alternativfrequenzen (oder zumindest diejenigen, die besser als die vom Hörempfänger aktuell verwendete) an den Hörempfänger, und dieser wird auf die gefundene Frequenz umgeschaltet, wenn sie besser ist. Bei dieser Ausgestaltung können zwar mehrere Frequenzwechsel stattfinden, bevor die beste Frequenz eingestellt ist, doch wird eine Émpfangsverbesserung gegebenenfalls schneller erreicht, weil nicht das Ende eines vollständigen Suchlaufs des Suchempfängers abgewartet werden muß.

Der Wechsel der Empfangsfrequenz durch Übertragen einer von dem Suchempfänger gefundenen Frequenz an den Hörempfänger und Abstimmen des Hörempfängers auf diese Frequenz kann in einem Rundfunkempfangssystem durchgeführt werden, in dem die Funktionen des Hörempfängers und des Suchempfängers jeweils einzelnen Empfängern fest zugewiesen sind, z.B. dadurch, daß allein der Hörempfänger über eine Verbindung zur Ausgabeeinrichtung verfügt.

Alternativ kann der Wechsel der Frequenz erfolgen durch Übertragen der Hörempfängerfunktion an den bisherigen Suchempfänger und Abstimmen des Suchempfängers auf die gefundene Frequenz. Bei dieser Variante des Verfahrens können Hörempfänger und Suchempfänger baugleich sein, sie müssen lediglich zwischen Hörempfänger- und Suchempfänger-Betriebszustand umschaltbar sein.

Der Suchempfänger verfügt zweckmäßigerweise über ein Speicherelement zum Speichern von gefundenen Frequenzen eines gegeben Senders und von Informationen über die Empfangsqualität des Senders bei jeder gefundenen Frequenz.

Verschiedene Empfänger eines Rundfunkempfangssystems tauschen zweckmäßigerweise Informationen über Empfangsqualität und/oder Befehle zum Wechseln des Betriebszustandes auf einem Datenbus wie insbesondere einem MOST-Bus aus.

Jedem Empfänger kann eine eigene Antenne zugeordnet sein. In einem solchen Fall ist es zweckmäßig, den Wechsel zu einer besseren Empfangsfrequenz durch Übermitteln der Hörempfängerfunktion an einen bisherigen Suchempfänger durchzuführen, da die Empfangsqualität, die der Suchempfänger mit seiner Antenne bei einer gegebenen Frequenz erreicht, nicht zwangsläufig einen Rückschluß auf die mit der Antenne des gegenwärtigen Hörempfängers bei der gleichen Frequenz erreichbare Empfangsqualität zuläßt.

Falls den Empfängern jeweils eigene Antennen zugeordnet sind, kann es vorteilhaft sein, mehr als einen Suchempfänger gleichzeitig zu betreiben, um bei einem Übergang der Hörempfänger-Funktion an einen anderen Empfänger nicht nur unterschiedliche Frequenzen, sondern auch unterschiedliche Antennen zur Auswahl zu haben.

Das erfindungsgemäße Rundfunkempfangssystem kann ferner wenigstens einen Datenempfänger für den Empfang von Datensignalen wie etwa RDS, TMC, Swift, DARC etc. aufweisen. Dabei unterscheidet sich die Arbeitsweise des Datenempfängers nicht zwangsläufig von der des Hörempfängers; allein die Verwendung der jeweiligen Empfangssignale in dem Rundfunkempfangssystem ist eine andere. Das heißt, auch für die Empfangsfrequenz des Datenempfängers kann ein Suchempfänger eingesetzt werden, um bessere Alternativfrequenzen zu ermitteln. Da der Datenempfang gegen Unterbrechungen der Übertragung wesentlich empfindlicher ist als die Audioübertragung - das menschliche Gehör vermag Lücken im Bereich von 100 ms zu interpolieren, ohne daß dies dem Hörer notwendigerweise bewußt wird -, wird man im Falle des Datenempfängers einen Frequenzwechsel eher bei Unterschreitung eines absoluten Grenzwertes der Empfangsqualität als eines relativen Grenzwertes vornehmen, um die Zahl der Frequenzwechsel und damit die Möglichkeit einer Lücke im Datenempfang so gering wie möglich zu halten.

Weitere Merkmale und Vorteile der Erfindung ergeben sich aus der nachfolgenden Beschreibung von Ausführungsbeispielen mit Bezug auf die beigefügten Figuren. Es zeigen:
Figur 1 ein Blockdiagramm eines erfindungsgemäßen Rundfunkempfangssystems; und
Figuren 2 bis 4 Flußdiagramme von Betriebsverfahren der Suchempfänger eines Empfangssystems der in Figur 1 gezeigten Art.

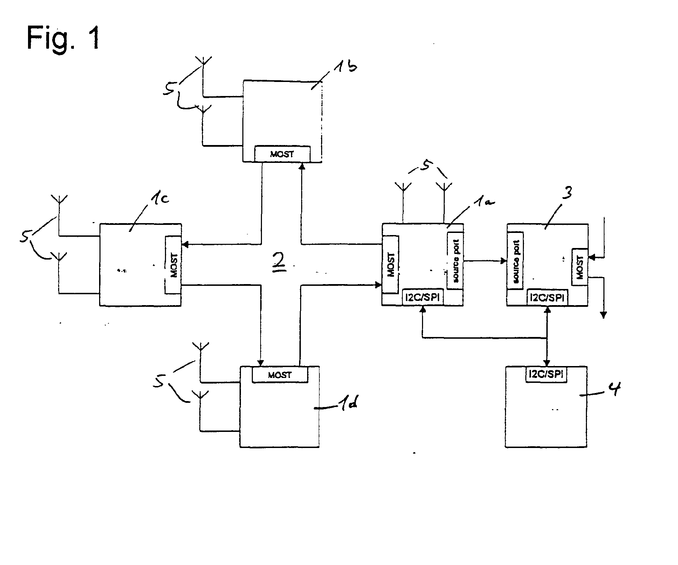

Das Rundfunkempfangssystem umfaßt wenigstens zwei Empfänger, genauer gesagt vier Empfänger 1a, 1b, 1c, 1d in dem in Figur 1 dargestellten Beispiel. Die einzelnen Empfänger sind untereinander durch einen MOST-Ring 2 verbunden. Auf dem MOST-Ring 2 tauschen die einzelnen Empfänger Informationen über die Identität eines zu empfangenden Senders und Empfangsqualitäten aus. An den Empfänger 1a ist eine Audiosignal-Verarbeitungseinheit 3 angeschlossen, die z.B. zum Verstärken und spektralen Formen des Audiosignals und zum Ausgeben an (nicht dargestellte) Lautsprecher dient. Ein externer Mikrocontroller 4 verfügt über Eingabeelemente zum Eingeben von Steuerbefehlen durch einen Benutzer, wie etwa zum Auswählen eines Senders, Regeln von Klang, Lautstärke und Balance, etc.. Der Mikrocontroller 4 ist an die Audiosignal-Verarbeitung 3 und nur an einen einzelnen Empfänger, den Empfänger 1a, angeschlossen. Dieser gibt vom Mikrocontroller 4 empfangene Befehle, soweit sie die Empfänger 1b, 1c, 1d betreffen, auf den MOST-Ring 2 weiter.

Bei dem in der Figur gezeigten Beispiel sind jedem Empfänger 1a, 1b, 1c, 1d je zwei eigene Antennen 5 zugeordnet. Die Erfindung ist allerdings auch auf Empfangssysteme anwendbar, die nur eine Antenne pro Empfänger oder nur eine Antenne für das gesamte System aufweisen, wobei auf daraus resultierende Besonderheiten im Betrieb des Systems im folgenden eingegangen wird.

Bei einer ersten Variante des Rundfunkempfangssystems der Figur 1 dient der Empfänger 1a immer als Hörempfänger, d.h. er liefert das Audiosignal, das von der Audiosignal-Verarbeitungseinheit 3 verstärkt und ausgegeben wird. Von den anderen Empfängern ist wenigstens einer ein Suchempfänger, und ein weiterer kann ein Datenempfänger sein.

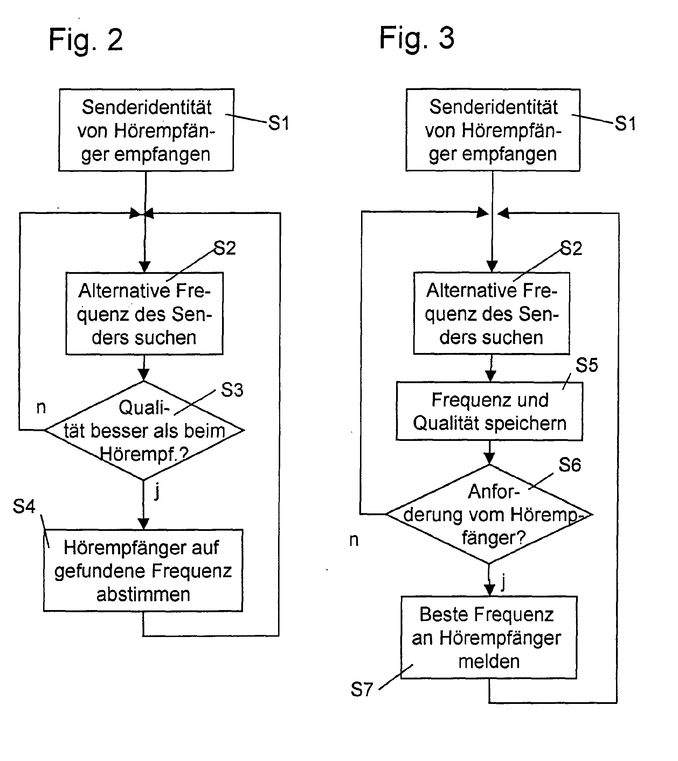

Betriebsverfahren des Suchempfängers werden mit Bezug auf Figuren 2 und 3 beschrieben.

Bei dem Verfahren der Figur 2 empfängt der Suchempfänger, z.B. der Empfänger 1b, vom Hörempfänger 1a in Schritt S1 eine Nachricht über die Identität des Senders, auf den der Hörempfänger 1a gegenwärtig abgestimmt ist. Der Suchempfänger 1b beginnt daraufhin, sein Frequenzband nach Frequenzen dieses Senders abzusuchen (Schritt S2), d.h. er führt ausgehend von einer Startfrequenz einen Sendersuchlauf durch, stimmt sich auf einen Sender mit einer benachbarten Frequenz ab und entscheidet anhand des von dem Sender übertragenen PI-Codes, ob es sich um den vom Hörempfänger spezifizierten Sender handelt oder nicht. Wenn nicht, wird die Suche fortgesetzt, wenn ja, muß in einem nächsten Schritt S3 entschieden werden, ob die Empfangsqualität bei der vom Suchempfänger 1b gefundenen Frequenz besser ist als die aktuell vom Hörempfänger 1a empfangene.

Diese Entscheidung kann z.B. getroffen werden, indem der Suchempfänger die Frequenz und die Empfangsqualität an den Hörempfänger meldet, und letzterer entscheidet, ob es vorteilhaft ist, auf die neu gefundene Frequenz umzuschalten. Alternativ besteht die Möglichkeit, daß der Hörempfänger 1a eine Meldung auf dem MOST-Ring 2 in Umlauf bringt, die die Qualität des aktuell von ihm empfangenen Signals angibt, so daß der Suchempfänger 1b die Entscheidung treffen kann, ob umgeschaltet werden soll oder nicht und ggf. einen Befehl zum Umschalten an den Hörempfänger 1a übermittelt.

Eine Umschaltung wird zweckmäßigerweise immer dann vorgenommen, wenn die Qualität bei der vom Suchempfänger gefundenen Frequenz die des Hörempfängers um einen vorgegebenen Differenzwert übersteigt. Als Meßgröße für die Qualität kann zum Beispiel die Empfangsfeldstärke oder der Signalrauschabstand verwendet werden.

Nach dem Umschalten des Hörempfängers auf die gefundene Frequenz (Schritt S4), kehrt das Verfahren zu Schritt S2 zurück. Die Schritte S2 bis S4 werden somit so lange zyklisch wiederholt, bis der Hörempfänger eine neue Senderidentität meldet.

Da der Suchempfänger 1b das gesamte empfangbare Frequenzband zyklisch durchmustert, wird auf diese Weise zwangsläufig auch die jeweils beste verfügbare Frequenz für den zu empfangenen Sender gefunden und für den Empfang genutzt.

Bei dem zweiten Betriebsverfahren der Figur 3 sind die Schritte S1 und S2 mit denen aus Figur 2 identisch. Allerdings wird eine gefundene Senderfrequenz nicht direkt an den Hörempfänger 1a übermittelt, sondern zunächst in einem Speicherelement des Suchempfängers 1b gespeichert. Der Suchempfänger legt auf diese Weise eine Tabelle aller Frequenzen an, auf denen der vom Hörempfänger spezifizierte Sender empfangbar ist (Schritt S5).

Auf den Empfang einer Anforderung vom Hörempfänger 1a (Schritt S6) meldet der Suchempfänger die jeweils beste gefundene Frequenz an den Hörempfänger über den MOST-Ring 2 (S7), und der Hörempfänger schaltet auf diese Frequenz unter den gleichen Voraussetzungen um, wie mit Bezug auf Figur 2 beschrieben.

Die Anforderung des Hörempfängers kann zyklisch ausgegeben werden, sie kann aber auch ausgegeben werden, wenn die gegenwärtig vom Hörempfänger erreichte Empfangsqualität einen gegebenen Grenzwert unterschreitet.

Die beiden oben beschriebenen Verfahren eignen sich besonders für Empfangssysteme, wo alle Empfänger an eine gemeinsame Antenne angeschlossen sind, da dann von den Empfangsqualitäten des Suchempfängers sicher auf die des Hörempfängers geschlossen werden kann. Sie sind auch geeignet für ein Empfangssystem, bei dem mehrere Antennen über ein Koppelfeld selektiv mit jedem Empfänger verbindbar sind, wobei in einem solchen Fall die in der Tabelle zu speichernde bzw. an den Hörempfänger zu übertragende Information nicht nur die gefundene Frequenz, sondern auch die zum Finden des Senders benutzte Antenne bezeichnen muß.

Gemäß einer zweiten, besonders für den Betrieb mit mehreren Antennen geeigneten Variante des Empfangssystems sind die einzelnen Empfänger 1a, 1b, 1c, 1d zwischen mehreren Betriebszuständen umschaltbar, zu denen wenigstens der Betrieb als Hörempfänger und der als Suchempfänger gehört. Im Hörempfänger-Betriebszustand führt ein Empfänger keinen Sendersuchlauf durch, denn in diesem Zustand ist seine Aufgabe, ein möglichst unterbrechungsfreies Audiosignal an die Verarbeitungseinheit 3 zu liefern. Beim Betrieb als Suchempfänger hingegen wird kein Audiosignal geliefert, sondern es wird ständig ein Sendersuchlauf durchgeführt. Ein weiterer Betriebszustand ist der Betriebszustand als Datenempfänger, dieser unterscheidet sich jedoch für die Empfänger selbst nicht wesentlich von dem Hörempfänger-Betriebszustand, allein die Verarbeitung der vom Empfänger gelieferten Signale in der Verarbeitungseinheit 3 ist für Hörempfänger und Datenempfänger unterschiedlich.

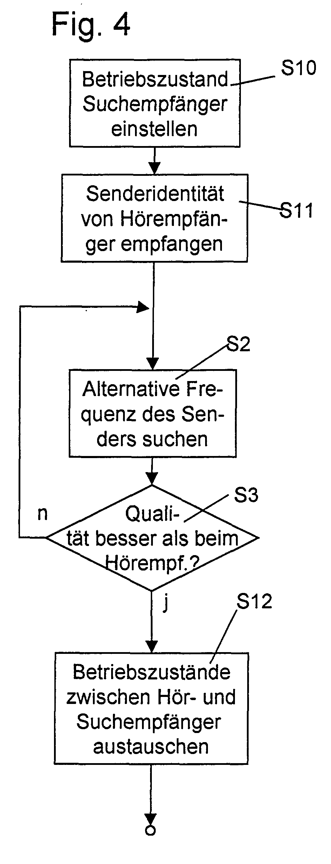

Beim Einschalten des Empfangssystems wird einem Empfänger, z.B. dem Empfänger 1a, der Betriebszustand des Hörempfängers vom Mikrocontroller zugewiesen. Andere Empfänger, z.B. die Empfänger 1b, 1c erhalten einen Befehl, den Betriebszustand Suchempfänger einzustellen (Schritt S10 in Figur 4). Genauso wie im Falle der Figuren 2 und 3 empfangen die Suchempfänger eine Nachricht über die Identität des zu empfangenden Senders (Schritt S11). Die Schritte S10 und S11 können zu einem zusammengefaßt werden, indem die Nachricht über den zu empfangenden Sender an den Empfänger, der als Suchempfänger dienen soll, adressiert wird und von diesem als Befehl aufgefaßt wird, als Suchempfänger zu arbeiten.

Die Schritte S2 des Suchens von Senderfrequenzen und S3 des Entscheidens, ob die Qualität der gefundenen Frequenz besser als die aktuelle Qualität des Hörempfängers ist, sind die gleichen wie mit Bezug auf Figur 2 beschrieben.

Wenn festgestellt wird, daß die von dem Suchempfänger 1b gefundene Frequenz einen besseren Empfang ermöglicht, so sendet dieser einen Befehl an den Hörempfänger 1a, in den Betriebszustand Suchempfänger überzugehen, und nimmt seinerseits den Betriebszustand Hörempfänger an. Das von dem neuen Hörempfänger, dem Empfänger 1b, gelieferte Audiosignal wird auf dem MOST-Ring 2 über den nun als Suchempfänger arbeitenden Empfänger 1a an die Verarbeitungseinheit 3 übertragen.

Bei dieser Variante des Verfahrens können mehrere jeweils mit einer eigenen Antenne 5 verbundene Suchempfänger und ein Hörempfänger zusammenarbeiten; es wird automatisch immer derjenige Empfänger zum Hörempfänger, dessen Antenne das beste Signal zu liefern vermag.

Es können auch jedem Empfänger mehrere Antennen 5 zugeordnet sein, wobei dann die Sendersuche der Schritte S2, S3 jeweils alternierend für die einzelnen Antennen durchgeführt wird.

Selbstverständlich besteht auch bei dieser Variante des Empfangssystems die Möglichkeit, die einzelnen Empfänger jeweils mit Speicherelementen zum Speichern von Empfangsfrequenzen und -qualitäten (sowie einer Bezeichnung der zugehörigen Antenne, falls dem Empfänger mehrere Antennen zugeordnet sind) auszurüsten und jeweils auf Anforderung des gerade als Hörempfänger arbeitenden Empfängers wie in Schritt S6 von Figur 3 zu überprüfen, ob andere Empfänger bessere Empfangsbedingungen zu gewährleisten vermögen.

Obwohl in den Ausführungsbeispielen u. a. bei der Funktion des Suchtuners beschrieben wurde, dass ein Sendersuchlauf in Verbindung mit einer PI-Code-Überprüfung zur Auffindung von Alternativfrequenzen möglich ist, kann alternativ hierzu noch die Auswertung der im RDS Datenstrom enthaltenen AF-Liste angewandt werden. Dies beschleunigt das Auffinden von möglichen Alternativen deutlich, indem zuerst die in der Liste aufgeführten Frequenzen geprüft werden, bevor der Sendersuchlauf über das gesamte Frequenzband gestartet wird.

## Patentansprüche

1. Verfahren zum Betreiben eines Rundfunkempfangssystems, das eine Mehrzahl von einer gemeinsamen Ausgabeeinrichtung (3) zugeordneten Empfängern (1a, 1b, 1c, 1d) umfaßt, bei dem jeweils einer der Empfänger (1a), als Hörempfänger bezeichnet, auf eine Frequenz eines Rundfunksenders abgestimmt ist und ein von dem Sender empfangenes Signal zur Ausgabe an die Ausgabeeinrichtung (3) liefert, **dadurch gekennzeichnet, daß** wenigstens ein zweiter Empfänger (1b, 1c), als Suchempfänger bezeichnet, das eigene Empfangsfrequenzband fortlaufend nach einer Frequenz des gleichen Senders absucht, und daß das System auf eine von dem Suchempfänger (1b, 1c) gefundene Frequenz dieses Senders wechselt, wenn die Qualität des von dem Hörempfänger (1a) empfangenen Signals einen Grenzwert unterschreitet.

2. Verfahren nach Anspruch 1, **dadurch gekennzeichnet, daß** der Grenzwert absolut festgelegt wird.

3. Verfahren nach Anspruch 1, **dadurch gekennzeichnet, daß** der Grenzwert relativ bezogen auf die Qualität einer von dem Suchempfänger gefundenen Frequenz festgelegt wird.

4. Verfahren nach einem der vorhergehenden Ansprüche, **dadurch gekennzeichnet, daß** der Suchempfänger eine Information über die Empfangsqualität bei jeder gefundenen Frequenz speichert, und daß der Frequenzwechsel des Systems zu derjenigen vom Suchempfänger gefundenen Frequenz erfolgt, die die beste Empfangsqualität liefert.

5. Verfahren nach einem der vorhergehenden Ansprüche, **dadurch gekennzeichnet, daß** der Wechsel durch Übermitteln der von dem Suchempfänger (1b, 1c) gefundenen Frequenz an den Hörempfänger (1a) und Abstimmen des Hörempfängers (1a) auf diese Frequenz erfolgt.

6. Verfahren nach einem der Ansprüche 1 bis 3, **dadurch gekennzeichnet, daß** der Wechsel durch Übertragen der Hörempfängerfunktion an den bisherigen Suchempfänger (1b 1c) und Abstimmen des Suchempfängers (1b, 1c) auf die gefundene Frequenz erfolgt.

7. Empfänger für ein Rundfunkempfangssystem durch Durchführung des Verfahrens nach einem der vorhergehenden Ansprüche, **dadurch gekennzeichnet, daß** er zwischen einem Hörempfänger-Betriebszustand und einem Suchempfänger-Betriebszustand umschaltbar ist, wobei der Empfänger (1a, 1b, 1c, 1d) im Suchempfänger-Betriebszustand das Empfangsfrequenzband auch dann nach Frequenzen eines gegebenen Senders absucht, wenn er eine Frequenz gefunden hat, die eine gegebene Mindestqualität erreicht.

8. Empfänger nach Anspruch 7, **dadurch gekennzeichnet, daß** er ein Speicherelement zum Speichern von gefundenen Frequenzen eines gegebenen Senders und von die Empfangsqualität bei jeder gefundenen Frequenz betreffender Information aufweist.

9. Rundfunkempfangssystem mit einer Mehrzahl von Empfängern nach Anspruch 7 oder 8, **dadurch gekennzeichnet, daß** die Empfänger (1a, 1b, 1c, 1d) Informationen über Empfangsqualität und/oder Befehle zum Wechseln des Betriebszustandes auf einem MOST-Bus (2) austauschen.

10. Rundfunkempfangssystem nach Anspruch 9, **dadurch gekennzeichnet, daß** jedem Empfänger (1a, 1b, 1c, 1d) wenigstens eine eigene Antenne (5) zugeordnet ist.

11. Rundfunkempfangssystem nach Anspruch 10, **dadurch gekennzeichnet, daß** es wenigstens zwei Suchempfänger (1b, 1c) aufweist.

12. Rundfunkempfangssystem nach Anspruch 9, 10 oder 11, **dadurch gekennzeichnet, daß** es wenigstens einen Datenempfänger (1d) aufweist.
